# EUROPÄISCHE PATENTANMELDUNG

(11) **EP 2 256 805 A2**
(43) Veröffentlichungstag der Anmeldung: **01.12.2010**
(21) Anmeldenummer: 10003120.2
(22) Anmeldetag: 24.03.2010
(51) Int. Cl.: H01L 25/07, H01L 23/04

(54) **Leitungshalbleitermodul mit Verbindungseinrichtung**

(30) Priorität: 28.05.2009 DE 102009023023
(71) Anmelder: Semikron Elektronik GmbH & Co. KG Patentabteilung, 90431 Nürnberg (DE)
(72) Erfinder: Bogen, Ingo, 90403 Nürnberg (DE); Walter, Alexej, 90431 Nürnberg (DE)

(57) **Zusammenfassung**

Die Erfindung beschreibt ein Leistungshalbleitermodul zur Anordnung auf einem externen Kühlbauteil, mit einem Gehäuse, mindestens einer Verbindungseinrichtung, mindestens einem Schaltungsträger mit einer hierauf ausgebildeten leistungselektronischen Schaltungsanordnung. Von dieser gehen elektrischen Last- und Steueranschlusselementen aus zur Verbindung mit externen Stromleitungen. Hierbei ist der Schaltungsträger als isolierendes Substrat oder als metallischer Formkörper mit einem isolierenden Substrat ausgebildet. Weiterhin ist die mindestens eine Verbindungseinrichtung ausgebildet als ein metallisches Druckgussformteil mit einem hohlzylinderförmigen Grundkörper und mit mindestens einem Fortsatz, wobei der mindestens eine Fortsatz) an der Außenseite des hohlzylinderförmigen Grundkörpers angeordnet und mit diesem einstückig verbunden ist. Ebenso ist die Verbindungseinrichtung spritztechnisch mit dem Gehäuse irreversibel verbunden angeordnet.

## Beschreibung

Die Erfindung beschreibt ein Leistungshalbleitermodul mit einem Gehäuse, mindestens einem vorzugsweise in einer Aussparung des Gehäuses angeordneten und von dem Gehäuse seitlich umschlossenen Substratträger mit einer hierauf ausgebildeten leistungselektronischen Schaltungsanordnung und von dieser ausgehenden elektrischen Anschlusselementen.

Beispielhaft ist in der DE 101 00 460 A1 ein Leistungshalbleitermodul der genannten Art offenbart, wie es in seiner Grundausprägung seit langem bekannt ist. Derartige Leistungshalbleitermodule gemäß dem Stand der Technik weisen einen Substratträger auf, der den unteren Abschluss des Leistungshalbleitermoduls bildet. Das Isolierstoffgehäuse überragt hierbei diesen Substratträger an seinen Längsseiten geringfügig um ihn zu umschließen. Derartige Substratträger sind häufig ausgebildet als ein flächiger Metallformkörper, vorzugsweise aus Kupfer. Hierdurch ist ein geringer Wärmewiderstand bei wirksamer Wärmespreizung für den Wärmetransport von der leistungselektronischen Schaltungsanordnung zu einem Kühlbauteil gegeben.

Gemäß dem Stand der Technik ist weiterhin bekannt, dass der Substratträger mit dem Gehäuse verklebt ist, um bei einer Befüllung des Gehäuses mit einem zu diesem Zeitpunkt flüssigen Isolierstoff, beispielhaft einem Silikonkautschuk, ein Ausfließen diese Silikonkautschuks zu verhindern. Weiterhin ist das Gehäuse mittels metallischer Nietverbindungen mit dem Substratträger verbunden. Diese Nietverbindungen sind als Hohlkörper mit einer durchgehenden Ausnehmung ausgebildet um ebenso eine Befestigung des Leistungshalbleitermoduls auf einem Kühlbauteil mittels einer Schraubverbindung zu ermöglichen. Gemäß dem Stand der Technik sind diese Nietverbindungen als Messingnieten ausgebildet, da diese auf Grund des Bleianteils des Messings eine gewisse Verformung ermöglichen und somit eine Nietverbindung erst möglich machen.

Auf dem Substratträger selbst ist isoliert von diesem die Schaltungsanordnung des Leistungshalbleitermoduls angeordnet. Hierbei sind verschiedene Schaltungsanordnungen mit Leistungstransistoren, Leistungsdioden und / oder Leistungsthyristoren bekannt. Die Schaltungsanordnung ist mittels isolierender Substrate, beispielhaft DCB- (direct copper bonding) Substrate, von dem Substratträger isoliert.

Weiterhin dem Stand der Technik zuzuordnen sind verschieden ausgestaltete Anschlusselemente für Last- und Hilfsanschlüsse. Hierbei sind verschiedene Verbindungstechnologien dieser Anschlusselemente mit dem Substrat oder den Leistungshalbleiterbauelementen der Schaltungsanordnung bekannt. Besonders bevorzugt sind hierbei Lötverbindungen, Druckkontaktverbindungen und / oder Drucksinterverbindungen. Zur externen Verbindung weisen vorzugsweise die Lastanschlusselemente Verbindungseinrichtung zur Schraubverbindung auf. Diese sind häufig ausbildet als in das Gehäuse lose eingebettete Schraubenmuttern mit Innengewinde und hierüber angeordnete Abschnitte der Anschlusselemente mit einer zum Innengewinde fluchtenden durchgehenden Ausnehmung. Hierbei ist es von Nachteil, dass die Schraubmuttern nicht gegen Herausfallen gesichert sind. Weiterhin können periphere Materialbereiche des Gehäuses bei Beaufschlagung mit dem Kraftmoment der Schraubenfixierung brechen bzw. während der Lebensdauer des montierten Leistungshalbleitermoduls unter der beaufschlagten Krafteinwirkung ermüden und Materialrisse oder -brüche erleiden.

Der Erfindung liegt somit die Aufgabe zugrunde, ein Leistungshalbleitermodul mit Verbindungseinrichtungen zu einem Kühlbauteil und / oder zu externen Stromleitungen vorzustellen, die materialstabilisierend ausgebildet sind und zudem einem kostengünstigen und automatisierbaren Herstellungsverfahren zugänglich sind.

Diese Aufgabe wird erfindungsgemäß gelöst, durch einen Gegenstand mit den Merkmalen des Anspruchs 1. Bevorzugte Ausführungsformen sind in den Unteransprüchen beschrieben.

Den Ausgangspunkt der Erfindung bildet ein Leistungshalbleitermodul mit einem Gehäuse, mindestens einem vorzugsweise in einer Aussparung des Gehäuses angeordneten und von dem Gehäuse seitlich, vorzugsweise allseits, umschlossenen Schaltungsträger, welcher sich vorzugsweise aus einem metallischen Formkörper und einem hierauf angeordneten isolierenden Substrat ausbildet, jedoch auch nur aus einem isolierenden Substrat bestehen kann. Auf einer dem Inneren des Leistungshalbleitermoduls zugewandten Hauptseite dieses Schaltungsträgers ist eine leistungselektronische Schaltungsanordnung mit Leiterbahnen und Halbleiterbauelementen ausgebildet, von welcher elektrische Anschlussflächen für Last- und Hilfsanschlüsse ausgehen. Eine dem Inneren des Leistungshalbleitermoduls abgewandte Hauptfläche des Schaltungsträgers bildet eine dem Kühlbauteil zugewandte Außenfläche oder den Teil einer Außenfläche des Leistungshalbleitermoduls.

Hierbei weist das Gehäuse Verbindungseinrichtungen auf. Diese sind jeweils ausgebildet als im Wesentlichen metallische Druckgussformteile mit einem hohlzylinderförmigen Grundkörper, vorzugsweise aus Aluminium- oder Zinkdruckguss und dienen der Anordnung des Leistungshalbleitermoduls auf einem externen Kühlbauteil und der Verbindung zu demselben. Weiterhin weist das Gehäuse des Leistungshalbleitermoduls vorzugsweise in einem nicht-zentralen Bereich der Grundfläche des Leistungshalbleitermoduls Ausnehmungen auf, welche zur Aufnahme jeweils eines Druckgussformteiles dient, welches jeweils die Ausnehmung verstärkt und mit einer glatten oder einer gewindeten Innenfläche zur Aufnahme beispielsweise einer Schraube oder eines Verbindungsbolzen dient. Das Druckgussformteil ist hierbei derart im Gehäuse angeordnet, dass die Schraube auf einer ersten Planfläche des ersten Druckgussformteil aufliegt und die zweite Fläche auf dem Kühlbauteil aufliegt oder geringfügig hiervon beabstandet ist.

Die Druckgussformteile sind in ihren jeweiligen Ausnehmungen angeordnet und spritztechnisch mit dem Gehäuse verbunden. Hierzu ist es erfindungsgemäß vorteilhaft, wenn das jeweilige Druckgussformteil an seinem Außenzylinder mindestens einen Fortsatz aufweist. Hierdurch wird die Verbindung mit dem Kunststoff des Gehäuses verbessert. Durch eine erfindungsgemäße Ausgestaltung des mindestens einen Fortsatzes werden weiterhin vorteilhaft die auftretenden mechanischen Kräfte gleichmäßig und materialschonend im Kunststoff des Gehäuses verteilt, wodurch Materialermüdung am Kunststoff minimiert wird. Vorzugsweise überdeckt ein Abschnitt des Fortsatzes hierbei den Schaltungsträger parallel zur Grundfläche des Leistungshalbleitermoduls, so dass bei der kraftschlüssigen Verbindung des Leistungshalbleitermoduls mit einem Kühlkörper jener Abschnitt des Fortsatzes stabilisierende Kräfte auf die Lage des Schaltungsträgers ausüben.
Für das Druckgussformteil ist es weiterhin bevorzugt, wenn der zylinderförmige Grundkörper des Druckgussformteils einstückig ausgebildete Materialvorsprünge aufweist, die am Außenmantel des Grundkörpers ausgebildet sind.

Es kann weiterhin besonders bevorzugt sein, wenn der Schaltungsträger in seiner Funktionalität durch sein isolierendes Substrat selbst ersetzt wird. Hierbei bildet das Substrat die Begrenzung des Leistungshalbleitermoduls und weist seinerseits die notwendigen Ausnehmungen für die Aufnahme der Verbindungsrichtung auf.

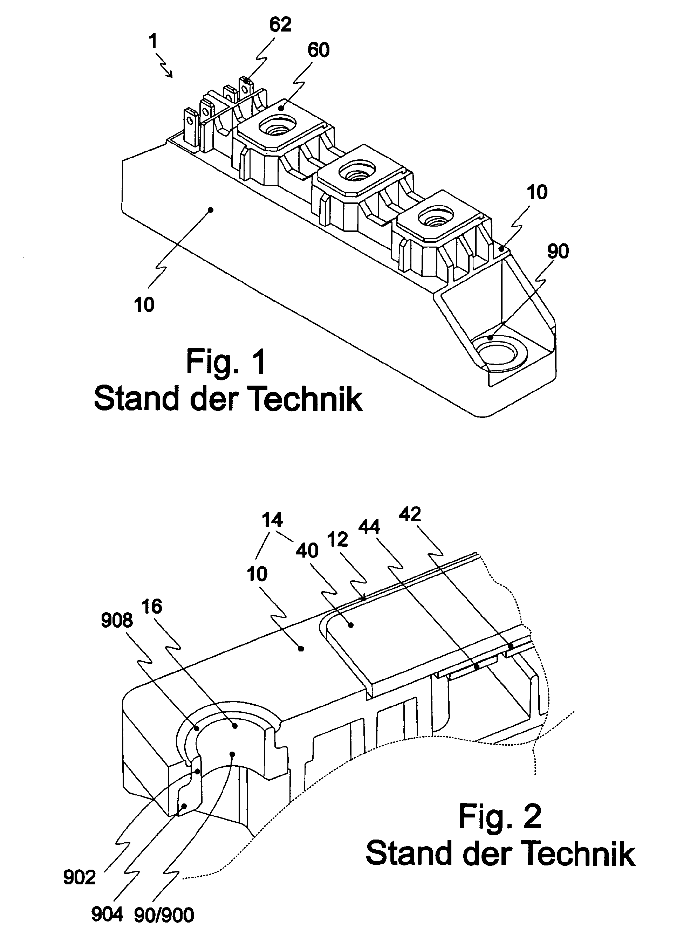

Besonders bevorzugte Weiterbildungen dieses Halbleiterbauelements sind in der jeweiligen Beschreibung der Ausführungsbeispiele genannt. Die erfinderische Lösung wird zudem an Hand der Ausführungsbeispiele und der Fig. 1 und 2 weiter erläutert.

Fig. 1 zeigt ein Leistungshalbleitermodul nach dem Stand der Technik in dreidimensionaler Draufsicht.

Fig. 2 zeigt einen Ausschnitt eines Leistungshalbleitermoduls nach dem Stand der Technik gemäß Fig.1 mit teilweisem dreidimensionalen Längsschnitt.

Fig. 3 zeigt einen Ausschnitt eines erfindungsgemäßen Leistungshalbleitermoduls mit einem Längsschnitt durch die Verbindungseinrichtung.

Fig. 4 zeigt eine erste Ausgestaltung einer Verbindungseinrichtung mit einem Fortsatz in dreidimensionaler Ansicht.

Fig. 5 zeigt eine zweite Ausgestaltung einer Verbindungseinrichtung mit zwei Fortsätzen in dreidimensionaler Ansicht.

Fig. 6 zeigt die zweite Ausgestaltung aus Fig. 5 in Draufsicht.

Fig. 7 zeigt die zweite Ausgestaltung der Verbindungseinrichtung aus Fig. 5 und 6 in ihrer Anordnung in einem ausschnittsartig dargestellten Leistungshalbleitermodul (1).

Fig. 8 zeigt die erste Ausgestaltung der Verbindungseinrichtung aus Fig. 4 in ihrer Anordnung in einem ausschnittsartig dargestellten Leistungshalbleitermodul (1).

Fig. 9 zeigt eine dritte Ausgestaltung einer Verbindungseinrichtung mit einem Fortsatz in dreidimensionaler Ansicht.

Fig. 1 zeigt ein Leistungshalbleitermodul (1) nach dem Stand der Technik in dreidimensionaler Ansicht. Das Leistungshalbleitermodul (1) besteht hierbei aus einem zweiteiligen Kunststoffgehäuse (10), aus einem temperaturstabilen Kunststoff, mit einem Grundkörper (110) und einem Deckel (102), wobei diese vorteilhafterweise mittels einer Schnapp- Rast- Verbindung zueinander angeordnet und miteinander verbunden sind. Der Grundkörper (10) weist zwei Ausnehmungen (16) zur Schraubverbindung mit einem nicht dargestellten Kühlbauteil auf. Diese Ausnehmungen (16) weisen als Druckgussformteile (90) ausgebildete Verbindungseinrichtungen auf, die spritztechnisch mit dem Grundkörper (100) des Gehäuses (10) verbunden sind. Diese Druckgussformteile (90) bestehen aus Aluminium- oder Zinkdruckguss.

Weiterhin dargestellt sind die Last- (60) und Hilfsanschlusselemente (62) des Leistungshalbleitermoduls (1). Die Hilfsanschlusselemente (62) sind hierbei mit Steckverbindungen ausgebildet, während die Lastanschlusselemente (60) mit Schraubverbindungen ausgebildet sind. Die Lastanschlusselemente (60) verbinden die leistungselektronische Schaltungsanordnung im Inneren des Leistungshalbleitermoduls (1) mit externen Anschlusselementen (nicht dargestellt).

Fig. 2 zeigt einen Ausschnitt eines Leistungshalbleitermoduls (1) nach dem Stand der Technik gemäß Fig. 1 im Längsschnitt. Dargestellt sind hierbei das Gehäuse (10) des Leistungshalbleitermoduls (1), sowie ein hiervon umschlossener Schaltungsträger (40), welche in ihrer gemeinsamen Außenebene die Grundfläche (14) des Leistungshalbleitermoduls bilden. Der Schaltungsträger (40) selbst besteht aus einem metallischen Formkörper und weist an seiner ersten inneren Hauptfläche angeordnet ein elektrisch isolierendes Substrat (42) auf, welches seinerseits Leiterbahnen (nicht dargestellt) und Halbleiterbauelemente (44) ausbildet. Von dieser gehen nicht dargestellt Hilfs- und Lastanschlusselemente (60) aus und reichen zur parallelen Oberfläche des Leistungshalbleitermoduls (1). Die äußere Hauptfläche (46) des Schaltungsträgers (40) bildet die Kontaktfläche zu einem Kühlbauteil.

Die im Wesentlichen hohlzylinderförmig ausgebildete Verbindungseinrichtung (90) ist in den Grundkörper (100) des Gehäuses (10) eingespritzt. Zur haltbaren Verbindung mit diesem Grundkörper (100) weist das Druckgussformteil (90) an seinem Außenzylinder (902) mindestens einen nasenartigen Fortsatz (904) auf, der rotationssymmetrisch um die Hochachse des Druckgussformteils (90) ausgebildet ist. An seinem Innenzylinder (900) weist das Druckgussformteil (90) der Verbindungseinrichtung eine glatte Oberfläche auf.

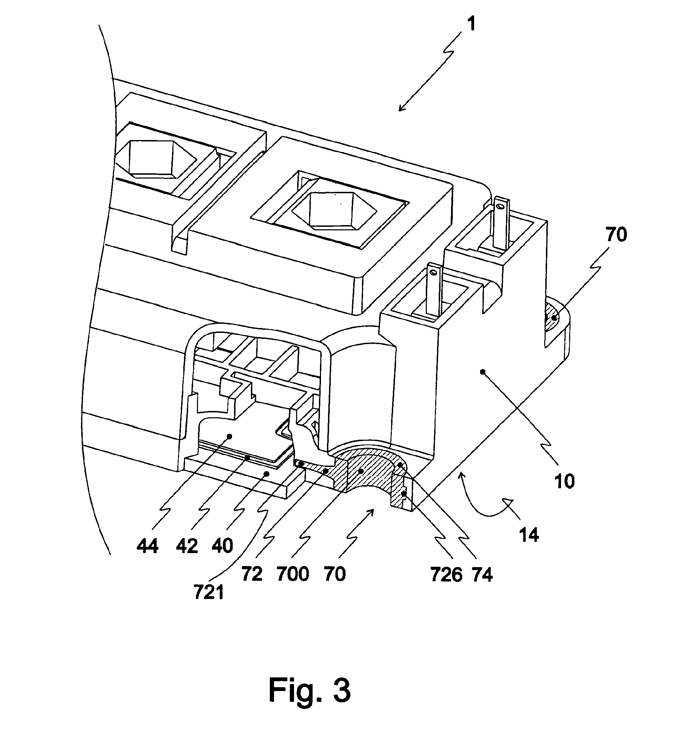

Fig.3 zeigt einen Ausschnitt eines erfindungsgemäßen Leistungshalbleitermoduls (1) mit einem teilweisen Längsschnitt durch die erfindungsrelevanten Aspekte. Dementsprechend sind baugleiche, die Erfindung nicht betreffende Teile des Leistungshalbleitermoduls mit denselben Bezugszeichen versehen wie die Fig. 1 und 2 des Standes der Technik und werden weiterhin nicht explizit beschrieben

Im vorderen Bereich des Leistungshalbleitermoduls wird durch einen Längsschnitt eine erfindungsgemäß ausgebildete Verbindungseinrichtung (70) sichtbar, welche ihrerseits durch den Längsschnitt ihre Ausgestaltung offenbart. Die Verbindungseinrichtung (70) ist in einer Ausnehmung im Gehäuse (10) angeordnet, welche sich im Randbereich des Leistungshalbleitermoduls befindet und den Schaltungsträger (40) des Leistungshalbleitermoduls unberührt lässt. Im hinteren Randbereich des Leistungshalbleitermoduls wird eine entsprechende, baugleiche Verbindungseinrichtung sichtbar. Jegliche Verbindungseinrichtung wird bei der Herstellung des Gehäusematerials entsprechend angeordnet und im Kunststoff-Spritzgussverfahren mit selbigem irreversibel verbunden.

Die Verbindungseinrichtung (70) besteht aus einem metallischen Druckgussformteil aus Aluminium und weist einen hohlzylinderförmigen Grundkörper (74) mit einer Innenseite (700) auf, welche glatt ausgebildet ist und zur Aufnahme eines Verbindungsbolzen (nicht dargestellt) dient. Weiterhin weist die Verbindungseinrichtung an der Außenseite des Grundkörpers einen Fortsatz (72) auf, der einstückig und schaufelförmig oder polygonal aus dem Material des Grundkörpers ausgebildet ist und zur horizontalen Ebene des Grundkörpers (74) fluchtet. Weiterhin weist der Grundkörper an seiner nicht vom Fortsatz überdeckten Fläche einen Materialvorsprung (726) auf, der ebenfalls einstückig aus dem Grundkörper ausgebildet ist und diesen bandartig umschließt.
Die Verbindungseinrichtung (70) ist in das Kunststoffmaterial des Gehäuses (10) eingespritzt und dabei dergestalt angeordnet, dass der Fortsatz fluchtend zur Grundfläche (14, siehe auch Fig.2, SdT) des Leistungshalbleitermoduls (1) angeordnet ist. Hierbei ermöglichen der Fortsatz (72) und der bandartige Materialvorsprung (726) an der Außenseite des Grundkörpers (74) eine stabile und verdrehsichere Verbindung mit dem Gehäusekunststoff im Spritzgussverfahren. Darüber hinaus gewährleistet der Fortsatz (72) bei der Beaufschlagung mit mechanischen Kräften, wie sie bei der kraftschlüssigen Verbindung bei der Montage mit dem Kühlkörper dauerhaft auftreten, eine optimale Verteilung der Kräfte auf das Gehäusematerial. Hierdurch können Spannungsrisse im Gehäusematerial bei der Montage sowie Materialermüdung des Gehäusematerials im Betrieb des Leistungshalbeitermoduls minimiert werden. Darüber hinaus überdeckt ein Abschnitt (721) des Fortsatzes (72) hierbei den Schaltungsträger (40) parallel zur Grundfläche (14) des Leistungshalbleitermoduls (1), so dass bei der kraftschlüssigen Verbindung des Leistungshalbleitermoduls mit einem Kühlkörper jener Abschnitt (721) des Fortsatzes stabilisierende Kräfte auf die Positionierung des Schaltungsträgers (40) ausübt.

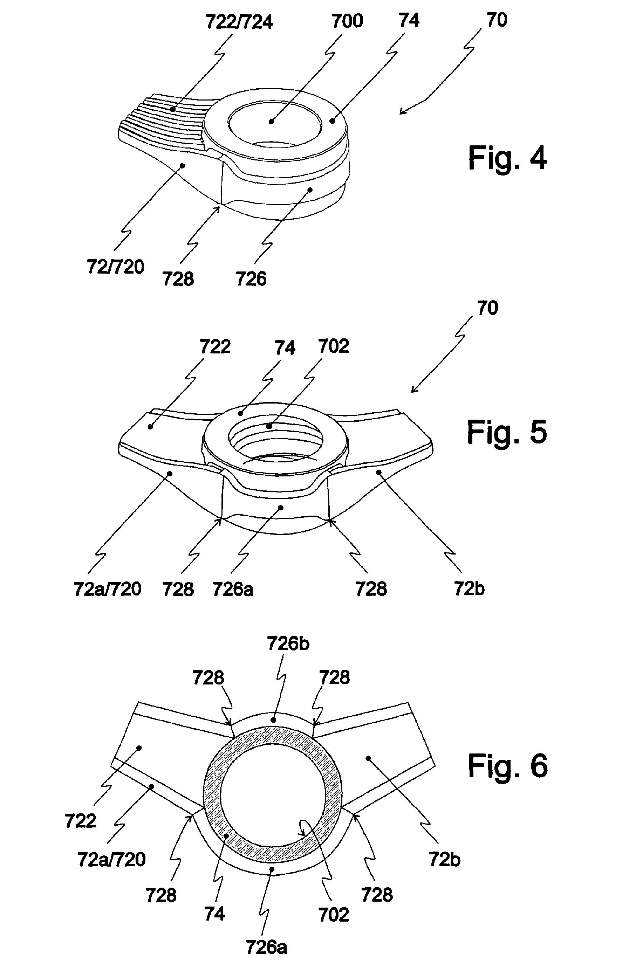

Fig. 4 zeigt eine erste Ausgestaltung einer Verbindungseinrichtung mit einem Fortsatz in dreidimensionaler Ansicht. Die Verbindungseinrichtung (70) besteht hierbei aus einem Druckgussformteil aus Zink und weist einen hohlzylinderförmigen Grundkörper (74) mit einer glatten Innenfläche (700) zur Aufnahme und Durchführung einer Schraub- oder Nietverbindung zur späteren Montage auf einem Kühlkörper auf. Weiterhin dargestellt ist der einstückig aus dem Grundkörper ausgebildete Fortsatz (72), welcher schaufelförmig (720) ausgebildet ist und mit der horizontalen Ebene des Grundkörpers fluchtet. Hierbei weist der schaufelförmige Fortsatz (72) eine Hauptfläche (722) auf, welche riefenartig (724) ausgestaltet ist. Hierbei dient die riefenartige Ausgestaltung sowohl der besseren Verbindung mit dem Kunststoffmaterial des Gehäuses bei der Anordnung in dessen Herstellung, als auch der beschriebenen gleichmäßigeren Kräfteverteilung zur Minimierung von Spannungskräften. Darüber hinaus dient die riefenartige Ausgestaltung vorzugsweise der Flächenstabilisierung des Fortsatzes sowie der Materialeinsparung bei der Erzeugung der Verbindungseinrichtung.

Weiterhin dargestellt ist ein Materialvorsprung (726) an der Außenseite des Grundkörpers (74). Der Materialvorsprung ist ebenfalls einstückig aus dem Material des Grundkörpers ausgebildet und umschließt diesen bandartig, bis er auf die jeweiligen Materialansätze des schaufelförmigen Fortsatzes trifft (728). Hierbei dient der Materialvorsprung der weiteren zuverlässigen Verbindung zwischen der Verbindungseinrichtung und dem Gehäusematerial.

Fig. 5 zeigt eine zweite Ausgestaltung einer Verbindungseinrichtung mit zwei Fortsätzen in dreidimensionaler Ansicht. Hierbei weist der Grundkörper (74) eine Innenfläche mit Gewinde (702) zur Aufnahme einer Schraubverbindung zur späteren Montage auf einem Kühlkörper auf. Weiterhin dargestellt sind zwei jeweils einstückig aus dem Grundkörper ausgebildete Fortsätze (72a, 72b), welche schaufelförmig (720) ausgebildet sind und jeweils mit der horizontalen Ebene des Grundkörpers fluchten. Hierbei ist die Hauptfläche (720) im Wesentlichen glatt ausgestaltet, da die optimale Kräfteverteilung in diesem Ausführungsbeispiel durch die Anordnung von zwei Fortsätzen (72a, 72b) gewährleistet wird und sich eine riefenartige Ausgestaltung der Oberfläche, wie in Fig. 4 dargestellt, erübrigt. Weiterhin dargestellt sind wiederum zwei bandartige Materialvorsprünge (726a, 726b, dieser in Fig. 5 nicht darstellbar, siehe aber Fig. 6) an der Außenseite des Grundkörpers (74). Die Materialvorsprünge (726a, 726b) sind wiederum durch die Materialansätze der Fortsätze (72a, 72b) begrenzt (jeweils 728).

Fig.6 zeigt die zweite Ausgestaltung einer Verbindungseinrichtung mit zwei Fortsätzen der Fig. 5 zur Verdeutlichung in Draufsicht, so dass die beiden bandartigen Materialvorsprünge (726a, 726b) und ihre Angrenzung zu den jeweiligen Materialansätzen der Fortsätze (jeweils 728 an 72a und 72b) sichtbar werden. Hierzu ist zum Zweck der optischen Verdeutlichung der Grundkörper (74) der Verbindungseinrichtung (70) schraffiert dargestellt.

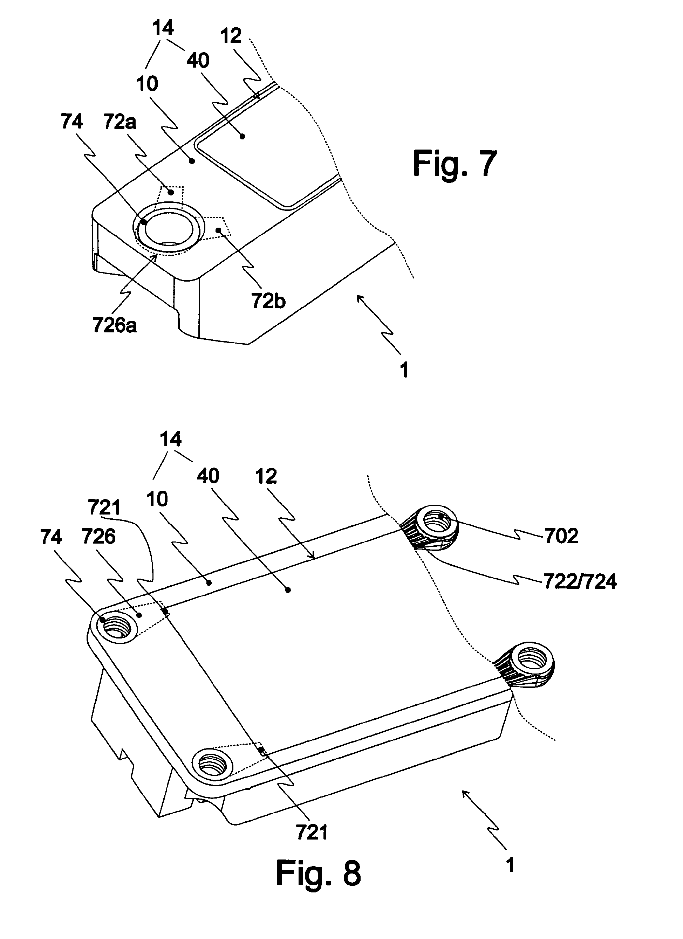

Fig. 7 zeigt die zweite Ausgestaltung der Verbindungseinrichtung in ihrer Anordnung in einem ausschnittsartig dargestellten Leistungshalbleitermodul (1). Dargestellt wird die Grundfläche (14) des Leistungshalbleitermoduls, die sich aus dem Schaltungsträger (40) und dessen Anordnung in einer Aussparung (12) des Gehäuses (10) ergibt (vgl. Fig. 2). Der Schaltungsträger selbst ist hierbei ausgebildet als isolierendes Substrat mit darauf angeordneten Leiterbahnen und Leistungshalbleiterbauelementen, so dass hier auf den in Fig. 2 dargestellten metallischen Formkörper verzichtet wird. Die Verbindungseinrichtung in ihrer entsprechenden Ausgestaltung aus Fig. 5 und 6 ist hierbei grob schematisch dargestellt mit der jeweiligen Lage der beiden Fortsätze (72a, 72b) sowie eines bandartigen Materialvorsprungs (726a). Auf die Darstellung des zweiten Materialvorsprungs (726b, vgl. Fig. 5 und 6) wurde aus Gründen der Übersichtlichkeit verzichtet.

Fig. 8 zeigt die erste Ausgestaltung der Verbindungseinrichtung in ihrer Anordnung in einem Leistungshalbleitermodul (1), wobei die Verbindungseinrichtung in vierfacher Ausgestaltung jeweils in einem nicht-zentralen Bereich des Gehäuses (10) angeordnet ist, nämlich in den Randeckbereichen der Grundfläche (14) des Leistungshalbleitermoduls, die sich wiederum aus dem Schaltungsträger (40) und dessen Anordnung in einer Aussparung (12) des Gehäuses (10) ergibt (vgl. Fig. 2). Die Verbindungseinrichtung in ihrer entsprechenden Ausgestaltung aus Fig. 4 ist hierbei grob schematisch dargestellt mit der jeweiligen Lage des schaufelförmigen Fortsatzes (72, 720), wobei die Hauptfläche (722) des Fortsatzes hierbei eine riefenartige Oberflächenstruktur (724) aufweist. Darüber hinaus überdeckt hier ein Abschnitt (721) des Fortsatzes (72) den Schaltungsträger (40) parallel zur Grundfläche (14) des Leistungshalbleitermoduls (1), so dass bei der kraftschlüssigen Verbindung des Leistungshalbleitermoduls mit einem Kühlkörper jener Abschnitt (721) des Fortsatzes stabilisierende Kräfte auf die Positionierung des Schaltungsträgers (40) ausübt (vgl. Fig. 3).

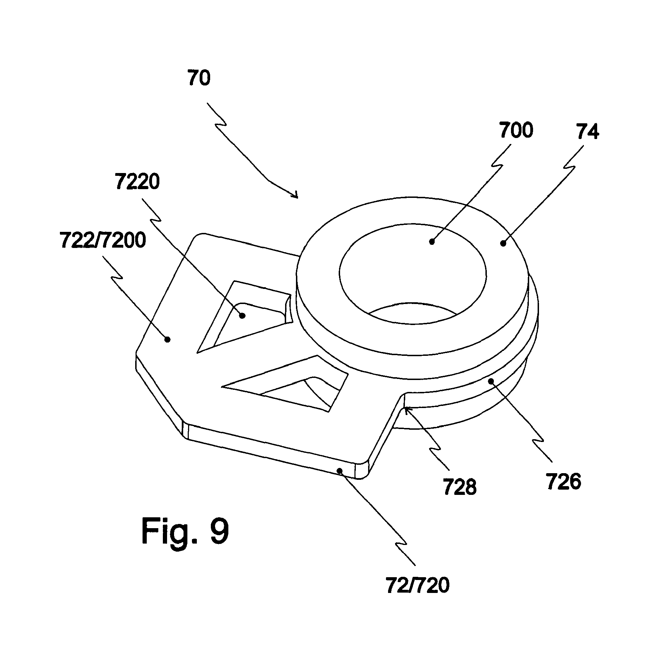

Fig. 9 zeigt eine dritte Ausgestaltung einer Verbindungseinrichtung mit einem Fortsatz in dreidimensionaler Ansicht. Die Verbindungseinrichtung (70) besteht hierbei wiederum aus einem Druckgussformteil aus Zink und weist einen hohlzylinderförmigen Grundkörper (74) mit einer glatten Innenfläche (700) zur Aufnahme und Durchführung einer Schraub- oder Nietverbindung zur späteren Montage auf einem Kühlkörper auf. Weiterhin dargestellt ist der einstückig aus dem Grundkörper ausgebildete Fortsatz (72), welcher polygonal (7200) ausgebildet ist und mit der horizontalen Ebene des Grundkörpers fluchtet. Hierbei weist der Fortsatz (72) eine Hauptfläche (722) auf, welche durch zwei Aussparungen (7220) unterbrochen ist. Hierbei dienen die beiden Aussparungen wiederum sowohl der besseren Verbindung mit dem Kunststoffmaterial des Gehäuses bei der Anordnung in dessen Herstellung, als auch der beschriebenen gleichmäßigeren Kräfteverteilung zur Minimierung von Spannungskräften, sowie der Materialeinsparung.

Weiterhin dargestellt ist ein Materialvorsprung (726) an der Außenseite des Grundkörpers (74). Der Materialvorsprung ist ebenfalls einstückig aus dem Material des Grundkörpers ausgebildet und umschließt diesen bandartig, bis er auf die jeweiligen Materialansätze des Fortsatzes trifft (728). Hierbei dient der Materialvorsprung der weiteren zuverlässigen Verbindung zwischen der Verbindungseinrichtung und dem Gehäusematerial.

## Patentansprüche

1. Leistungshalbleitermodul (1) zur Anordnung auf einem externen Kühlbauteil, mit einem Gehäuse (10), mindestens einer Verbindungseinrichtung (70), mindestens einem Schaltungsträger (40) miteiner hierauf ausgebildeten leistungselektronischen Schaltungsanordnung (50) und von dieser ausgehenden elektrischen Last- (60) und Steueranschlusselementen (62) zur Verbindung mit externen Stromleitungen, wobei der Schaltungsträger (40) als isolierendes Substrat oder als metallischer Formkörper mit einem isolierenden Substrat ausgebildet ist,
wobei die mindestens eine Verbindungseinrichtung (70) ausgebildet ist als ein metallisches Druckgussformteil mit einem hohlzylinderförmigen Grundkörper (74) und mit mindestens einem Fortsatz (72),
wobei der mindestens eine Fortsatz (72) an der Außenseite des hohlzylinderförmigen Grundkörpers (74) angeordnet und mit diesem einstückig verbunden ist, und die Verbindungseinrichtung (70) spritztechnisch mit dem Gehäuse (10) irreversibel verbunden angeordnet ist.

2. Leistungshalbleitermodul nach Anspruch 1,
wobei der Schaltungsträger (40) in einer Aussparung (12) des Gehäuses (10) angeordnet und von dem Gehäuse (10) seitlich umschlossen ist und wobei der Schaltungsträger (40) mit dem Gehäuse (10) eine Grundfläche (14) des Leistungshalbleitermoduls (1) ausbildet..

3. Leistungshalbleitermodul nach Anspruch 1,
wobei die mindestens eine Verbindungseinrichtung (70) aus Aluminium- oder Zinkdruckguss besteht.

4. Leistungshalbleitermodul nach Anspruch 1,
wobei der mindestens eine Fortsatz (72) schaufelförmig (720) oder polygonal (7200) fluchtend zur horizontalen Ebene des Grundkörpers (74) angeordnet ist.

5. Leistungshalbleitermodul nach Anspruch 1,
wobei der mindestens eine Fortsatz (72) mindestens eine Aussparung (7220) aufweist.

6. Leistungshalbleitermodul nach Anspruch 1,
wobei die mindestens eine Verbindungseinrichtung (70) an der Innenseite (700) des Grundkörpers (74) ein Gewinde (702) zur Aufnahme einer Schraubverbindung aufweist.

7. Leistungshalbleitermodul nach Anspruch 1,
wobei der Grundkörper (74) an seiner Außenseite mindestens einen bandartigen, einstückig aus dem Grundkörper ausgebildeten Materialansatz (726) aufweist.

8. Leistungshalbleitermodul nach Anspruch 4,
wobei der mindestens eine schaufelförmige (720) Fortsatz (72) mindestens eine Hauptfläche (722) aufweist und wobei die mindestens eine Hauptfläche eine riefenartige Oberflächenstruktur (724) aufweist.

9. Leistungshalbleitermodul nach Anspruch 1,
wobei die mindestens eine Verbindungseinrichtung (70) fluchtend zur Grundfläche (14) des Leistungshalbleitermoduls (1) in einem nicht-zentralen Bereich des Leistungshalbleitermoduls angeordnet ist.

10. Leistungshalbleitermodul nach Anspruch 1,
wobei ein Abschnitt (721) des mindestens einen Fortsatzes (72) den Schaltungsträger (40) parallel zur Grundfläche (14) des Leistungshalbleitermoduls (1) teilweise überdeckt.
